# EUROPEAN PATENT APPLICATION

(11) **EP 4 304 310 A1**
(43) Date of publication of application: **10.01.2024**
(21) Application number: 22774097.4
(22) Date of filing: 16.03.2022
(51) Int. Cl.: H05K 7/20

(54) **HEAT DISSIPATION APPARATUS FOR OPTICAL MODULE, AND COMMUNICATION DEVICE**

(30) Priority: 25.03.2021 CN 202110321865
(71) Applicant: Huawei Technologies Co., Ltd., Shenzhen, Guangdong 518129 (CN)
(72) Inventor: LI, Xiaodong, Shenzhen, Guangdong 518129 (CN); RONG, Huabin, Shenzhen, Guangdong 518129 (CN); LU, Dongming, Shenzhen, Guangdong 518129 (CN)
(74) Representative: Gill Jennings & Every LLP
(86) International application number: PCT/CN2022/081117
(87) International publication number: WO 2022/199436

(57) **Abstract**

This application provides a heat dissipation apparatus for an optical module, and a communication device, and relates to the field of communication device technologies, to resolve a problem of poor heat dissipation performance of an optical module. The heat dissipation apparatus for an optical module provided in this application includes a heat dissipation substrate, including a plurality of first heat dissipation parts, a plurality of adapter parts, and a second heat dissipation part. The plurality of first heat dissipation parts are in a one-to-one correspondence with the plurality of adapter parts. Each adapter part is configured to connect the first heat dissipation part corresponding thereto and the second heat dissipation part, and the plurality of first heat dissipation parts, the plurality of adapter parts, and the second heat dissipation part are integrally formed.

## Description

This application claims priority to Chinese Patent Application No. 202110321865.8, filed with the China National Intellectual Property Administration on March 25, 2021 and entitled "HEAT DISSIPATION APPARATUS FOR OPTICAL MODULE, AND COMMUNICATION DEVICE", which is incorporated herein by reference in its entirety.

### TECHNICAL FIELD

This application relates to the field of communication device technologies, and in particular, to a heat dissipation apparatus for an optical module, and a communication device.

### BACKGROUND

An optical module is an important constituent part in a communication network, and a main function of the optical module is to implement mutual conversion between light and electricity signals. With the upgrading and evolution of the communication network, a volume and a transmission rate of communication data in the communication network have been significantly improved. Therefore, all constituent parts in the communication network need to have good performance. After performance of the optical module is improved, power consumption of the optical module also increases, which causes serious heating. The head of the optical module accounts for a high proportion of the heat. Therefore, how to improve heat dissipation performance of the optical module becomes an urgent technical problem to be resolved.

### SUMMARY

Embodiments of this application provide a heat dissipation apparatus for an optical module, and a communication device, to resolve a problem of a poor heat dissipation effect in a conventional technology.

According to a first aspect, this application provides a heat dissipation apparatus for an optical module, including a heat dissipation substrate and a plurality of bosses. The heat dissipation substrate includes a plurality of first heat dissipation parts, a plurality of adapter parts, and a second heat dissipation part. The plurality of first heat dissipation parts are in a one-to-one correspondence with the plurality of adapter parts. The adapter part is configured to connect the first heat dissipation part corresponding thereto and the second heat dissipation part. The plurality of first heat dissipation parts, the plurality of adapter parts, and the second heat dissipation part are integrally formed. The plurality of bosses are in a one-to-one correspondence with the plurality of first heat dissipation parts, and are configured to conduct heat of the optical module to the heat dissipation substrate. One end of a boss is in contact with the optical module, and the other end of the boss is in contact with a corresponding first heat dissipation part.

It should be noted that, the first heat dissipation part is generally located above each optical module, and is configured to dissipate heat of the single optical module. Therefore, the first heat dissipation part may also be referred to as an optical module heat sink. The second heat dissipation part is located behind the plurality of first heat dissipation parts, and is configured to dissipate heat of a plurality of optical modules. Therefore, the second heat dissipation part may also be referred to as a common heat sink.

Based on the heat dissipation apparatus provided in embodiments of this application, the optical module heat sinks may be communicated with the common heat sink through the plurality of adapter parts, so that heat of the optical modules is transferred to the common heat sink, to prevent overloading of a single optical module heat sink. Through the foregoing heat dissipation apparatus, a temperature difference between the plurality of optical modules can be reduced, and temperature cascading of the optical modules can be implemented, thereby implementing sharing of heat dissipation resources in the entire heat dissipation apparatus, and improving a heat dissipation capability of the optical modules.

The heat dissipation apparatus for an optical module provided in embodiments is especially applicable to a scenario in which the plurality of optical modules work at the same time. A larger quantity of current optical modules indicates a greater temperature difference between optical modules at upstream and downstream, different positions. As a result, it is difficult to dissipate heat of downstream modules. According to the heat dissipation apparatus provided in embodiments of this application, a heat dissipation resource can be shared among the plurality of optical modules, to improve heat dissipation efficiency of the plurality of optical modules.

In a possible implementation, the first heat dissipation parts, the adapter parts, and the second heat dissipation part each include a substrate housing and a capillary structure layer. The capillary structure layer is sintered on an inner surface of the substrate housing, and is configured to implement cyclic heat dissipation. That the plurality of first heat dissipation parts, the plurality of adapter parts, and the second heat dissipation part are integrally formed includes: The substrate housing and the capillary structure layer are integrally formed.

Through the foregoing implementation, an integrated heat dissipation apparatus is used for the optical module, and heat generated by the optical module may be transferred from the first heat dissipation part to the second heat dissipation part through the adapter part, to implement sharing of heat dissipation resources with another optical module. In addition, through arrangement of the capillary structure layer, a heat dissipation process can be cyclically performed to improve a heat dissipation effect.

In a possible implementation, the heat dissipation substrate further includes: a vacuum cavity. The vacuum cavity is obtained by vacuumizing an inner cavity of the heat dissipation substrate. The vacuum cavity is filled with a phase change working substance, and is configured to transfer the heat of the optical module through gasification.

In the foregoing implementation, the interior of the heat dissipation substrate is vacuumized to implement the vacuum cavity, which can enable the phase change working substance to reach a state in which the phase change working substance is very easily evaporated, thereby implementing fast heat dissipation of the optical module, and ensuring that an inner wall of the heat dissipation substrate is not corroded or contaminated.

In another possible implementation, that each adapter part is configured to connect the first heat dissipation part corresponding thereto and the second heat dissipation part includes: Each first heat dissipation part, each adapter part, and the second heat dissipation part communicate with each other through the vacuum cavity. In this way, heat generated by the optical module may be quickly transferred from the first heat dissipation part to the second heat dissipation part through the adapter part, to implement sharing of heat dissipation resources and ensure temperature uniformity throughout the interior of the heat dissipation apparatus.

In a possible implementation, the first heat dissipation part and the second heat dissipation part further each include a support column and a capillary powder layer. The support column is located between an upper layer and a lower layer of a substrate housing, and is configured to support the substrate housing. The capillary powder layer is circumferentially sintered on an outer layer of the support column. After the heat generated by the optical module is cooled and liquefied on an upper layer of the heat dissipation substrate, the capillary powder layer or the capillary structure layer is configured to guide the cooled and liquefied liquid to a lower layer of the heat dissipation substrate. No support column or capillary powder layer is arranged in the vacuum cavity of the adapter part. In this way, flexibility of the adapter part can be ensured, to absorb a tolerance brought by insertion and removal of the optical module, and ensure normal insertion and removal of the optical module.

In a possible implementation, the plurality of first heat dissipation parts are parallel to each other in a first direction, and are arranged side by side and perpendicular to the second heat dissipation part. The first direction is an insertion and removal direction of the optical module. In this way, the plurality of first heat dissipation parts are arranged in parallel in a horizontal direction, and in addition, are all perpendicular to the second heat dissipation part and in a piano keyboard shape as a whole. This can effectively reduce a volume of the heat dissipation apparatus, reduce space occupied by the heat dissipation apparatus, and improve heat dissipation efficiency of a communication device.

In a possible implementation, a material of the capillary structure layer and/or a material of the capillary powder layer are/is copper powder. In this way, when the phase change working substance is cooled and liquefied above the heat dissipation substrate, an absorption effect inside the heat dissipation substrate can be enhanced, and the liquid is guided back to below the heat dissipation substrate through a capillary force, and participates in thermal cycling again, to implement fast heat dissipation of the optical module.

In a possible implementation, the phase change working substance is water. It should be noted that, selection of a phase change working substance 3303 is mainly related to a working temperature of the heat dissipation apparatus, and liquid properties, such as a specific heat capacity and a boiling point, are also factors taken into account. A general working temperature of the existing heat dissipation apparatuses is about 60 degrees Celsius. Therefore, water is generally selected as the phase change working substance. Because in liquids, water has a high specific heat capacity and a low freezing point, is easy to boil and low in costs, water is generally the first choice for the heat dissipation apparatus. Certainly, if the heat dissipation apparatus has a low temperature, substances, such as acetone and liquid ammonia, may also be used because acetone and liquid ammonia have low freezing points, which can prevent the heat dissipation apparatus from failing to normally dissipate heat due to freezing of the phase change working substance during working. In addition, a chemical substance, such as anhydrous alcohol, may also be used as the phase change working substance. Specifically, this is not limited in this application.

In a possible implementation, the heat dissipation apparatus further includes a heat dissipation fin. The heat dissipation fin is arranged on an outer surface of the heat dissipation substrate, and is configured to dissipate heat to the outside of the heat dissipation apparatus. Existence of the heat dissipation fin can increase a heat dissipation area of the heat dissipation substrate. In addition, when the heat of the optical module is transferred to the first heat dissipation part, a temperature of the heat dissipation fin is lower than a temperature of the body of the first heat dissipation part, the phase change working substance evaporates and absorbs heat, and steam reaches the heat dissipation fin and is liquefied when being cooled. The heat is dissipated into the air through heat exchange with an airflow.

In a possible implementation, the heat dissipation substrate further includes: a first substrate, where the first substrate is welded on a surface of the first heat dissipation part, and is configured to support the first heat dissipation part and assist the first heat dissipation part in dissipating heat; and/or a second substrate, where the second substrate is welded on a surface of the second heat dissipation part, and is configured to support the second heat dissipation part and assist the second heat dissipation part in dissipating heat.

In the foregoing heat dissipation apparatus for an optical module, the heat dissipation substrate is essentially a phase change substrate, and a main function of the heat dissipation substrate is to quickly transfer heat of the optical module. In addition, a support column needs to be arranged inside the heat dissipation substrate to support an inner cavity of the substrate. In this implementation, the first substrate and the second substrate are respectively added to the first heat dissipation part and the second heat dissipation part, and not only replace the support column to support the first heat dissipation part and the second heat dissipation part of the heat dissipation substrate, to simplify a manufacturing process of the heat dissipation substrate and reduce heat dissipation costs, but also can assist the first heat dissipation part and the second heat dissipation part in dissipating heat, and quickly transfer the heat of the optical module to the outside of the device, to improve heat dissipation efficiency.

In a possible implementation, the first substrate or the second substrate is a metal plate. Because of having some rigidity, the metal plate not only can support the heat dissipation substrate, but also has good thermal conductivity, which can improve heat dissipation efficiency of the heat dissipation apparatus.

In a possible implementation, the substrate housing is made of a rigid metal material. In this way, the substrate housing is strong enough to protect the internal heat dissipation apparatus from being damaged.

In a possible implementation, that the other end of the boss is in contact with the first heat dissipation part means that: An upper surface of the boss is welded to a lower surface of the corresponding first heat dissipation part.

In another possible implementation, the boss is made of a heat-conducting graphene material. Optionally, to achieve a better heat conduction effect, the boss may further include a thermal pad. The thermal pad may be bonded to the first heat dissipation part by a bonding structure, or may be connected to the first heat dissipation part by a connector. Certainly, another connection structure may alternatively be used to connect the thermal pad to the first heat dissipation part.

It should be understood that, regardless of how the boss is connected to the first heat dissipation part, to improve heat conduction efficiency, the boss should preferably be in surface contact with the first heat dissipation part. In this way, compared with discrete point contact, surface contact can effectively improve the heat conduction efficiency.

It should be noted that, to further improve the heat conduction efficiency, flatness and roughness of contact surfaces between the boss and the first heat dissipation part need to be as small as possible, to reduce thermal resistance between the contact surfaces and improve the heat conduction efficiency.

It should be noted that, flatness, also referred to as evenness, is one of the key indicators for evaluating quality of a formed surface, and is a deviation of a measured surface height from an ideal plane, which directly affects a bonding effect and fastening performance between components. Roughness refers to unevenness of a to-be-measured surface with small gaps and tiny peaks and valleys. The smaller the roughness of a surface, the smoother the surface.

According to a second aspect, an embodiment of this application provides a communication device. The communication device includes: the heat dissipation apparatus for an optical module according to the first aspect and any possible implementation of the first aspect, and further includes a PCB board and the optical module. The PCB board has a jack, and the jack is configured for insertion of the optical module.

In the heat dissipation apparatus for an optical module provided in this application, the first heat dissipation parts, the second heat dissipation part, and the adapter parts are arranged on the heat dissipation substrate, and the optical module heat sinks communicate with the common heat sink through the adapter parts, to transfer heat of optical modules to the common heat sink. The plurality of optical modules communicate with each other through the internal cavity to dissipate heat together, to prevent overloading of a single optical module heat sink. Through the foregoing heat dissipation apparatus, a temperature difference between the plurality of optical modules can be reduced, and temperature cascading of the optical modules can be implemented, thereby implementing sharing of heat dissipation resources in the entire heat dissipation apparatus, and improving a heat dissipation capability of the optical modules.

### BRIEF DESCRIPTION OF DRAWINGS

FIG. 1 is a schematic diagram of a structure of a communication device;
FIG. 2 is a schematic diagram of a structure of a heat pipe;
FIG. 3 is a top view of a heat dissipation apparatus for an optical module according to an embodiment of this application;
FIG. 4 is a side view of the heat dissipation apparatus for an optical module shown in FIG. 3 according to an embodiment of this application;
FIG. 5 is a schematic diagram of an internal structure of a heat pipe according to an embodiment of this application;
FIG. 6A is a top view of a heat dissipation apparatus for an optical module according to an embodiment of this application;
FIG. 6B is a side view of the heat dissipation apparatus for an optical module shown in FIG. 6A according to an embodiment of this application;
FIG. 7A is a side cross-sectional view of a heat dissipation substrate according to an embodiment of this application;
FIG. 7B is a top cross-sectional view of the heat dissipation substrate shown in FIG. 7A according to an embodiment of this application; and
FIG. 8 is a side view of another heat dissipation apparatus for an optical module according to an embodiment of this application.

### DESCRIPTION OF EMBODIMENTS

To make the objectives, technical solutions, and advantages of this application clearer, the following further describes a heat dissipation apparatus for an optical module, and a communication device in detail with reference to the accompanying drawings.

For ease of understanding of an optical module assembly provided in embodiments of this application, the following first describes an optical module in detail.

In a data transmission phase of an optoelectronic communication system, data information is transmitted in a form of optical signals in media such as fibers and cables, to implement low-cost and low-loss information transmission. In a data processing phase, a communication device (such as a computer) uses electrical signals. Therefore, to facilitate processing of the data information, the data information in the form of optical signals needs to be converted into a form of electrical signals.

A main function of the optical module is to implement mutual conversion between the foregoing optical signals and the foregoing electrical signals. Therefore, in an optoelectronic communication system, the optical module plays a particularly important role. Functionally, the optical module mainly includes a transmit part and a receive part. The optical module relies on the transmit part to convert electrical signals to optical signals and relies on the receive part to convert optical signals to electrical signals. For example, the transmit part is configured to: input an electrical signal with a specific bit rate, and drive, after the electrical signal is processed by an internal drive chip, a semiconductor laser device or a light emitting diode to emit an optical signal with a corresponding rate. The transmit part can be internally equipped with an automatic optical power control circuit to keep power of the output optical signal stable. The receive part is configured to: convert, through a photodetector diode, an optical signal with a specific bit rate into an electrical signal after the optical signal is input into the optical module, and then, output, after the electrical signal passes through a preamplifier, an electrical signal with a corresponding bit rate.

It should be noted that, unless otherwise specified, the optical module in this application is an optical module in a broad sense, and refers to a device that has an optical signal transmitting function or an optical signal receiving function, or can implement mutual conversion between optical and electrical signals. In addition, other functions, forms, and the like of the optical module are not limited in this application.

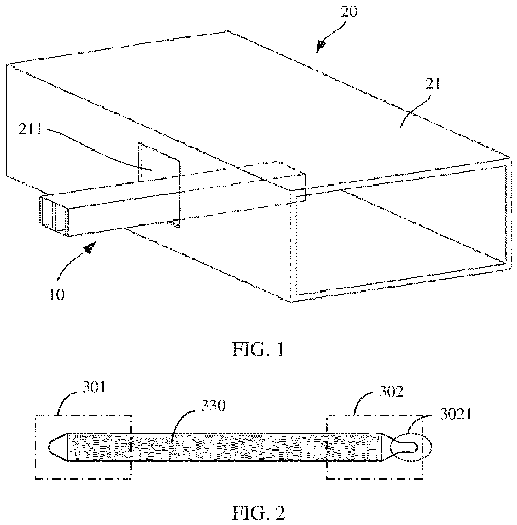

FIG. 1 is a schematic diagram of a structure of a communication device. As shown in FIG. 1, in an actual application of an optical module 10, the optical module 10 is generally plugged into a communication device 20, to implement a connection between the optical module 10 and the communication device 20. Specifically, a jack 211 that helps connect to the optical module 10 is arranged in a housing 21 of the communication device 20. A part of the optical module 10 may extend into the housing 21 through the jack 211, and an other part is exposed outside the housing 21.

With the continuous development of the optoelectronic communication system, a capacity of data information carried in the communication system is increasingly large, and a transmission rate of the data information is also increasingly high. When the optical module 10 and the communication device 20 process a large amount of data information, power consumption of the optical module 10 and the communication device 20 is significantly increased, resulting in an obvious increase in generated heat.

To improve heat dissipation performance of the optical module 10, a heat pipe 330 may be arranged on a surface of the optical module 10.

FIG. 2 is a schematic diagram of a structure of a heat pipe. Refer to FIG. 2. The heat pipe 330 has a hot end 301 and a cold end 302 that are opposite to each other. The heat pipe is vacuumized inside. The hot end 301 of the heat pipe 330 is in contact with a heating surface of the optical module 10, and is configured to absorb heat generated by the optical module 10 and conduct the heat to the cold end 302 of the heat pipe 330. The cold end 302 of the heat pipe is configured to dissipate the heat outside the optical module 10, thereby implementing heat dissipation of the optical module 10. In addition, the heat pipe 330 further has a port 3021 for injecting a phase change working substance into the heat pipe 330 after the interior of the heat pipe 330 is vacuumized, and then, the port 3021 is sealed. The phase change working substance may be a liquid with a high specific heat capacity, and is configured to absorb heat through a gasification process when being heated. An inner diameter of the port 3021 is narrow to ensure air tightness inside the heat pipe.

However, when high-power-consumption optical modules are arranged at a high density in an existing communication device, due to independent heat dissipation of the optical modules, a temperature difference between the optical modules is large, and temperature uniformity cannot be achieved, which degrades processing performance of the optical modules and the communication device and reduces service lives of the optical modules and the communication device.

Therefore, an embodiment of this application provides a heat dissipation apparatus for an optical module that can improve heat dissipation performance of the optical module 10.

To make the objectives, technical solutions, and advantages of this application clearer, the following further describes this application in detail with reference to the accompanying drawings and specific embodiments.

Terms used in the following embodiments are merely intended to describe specific embodiments, but are not intended to limit this application. Terms "one", "a", "the foregoing", "the", and "the one" of singular forms used in this specification and the appended claims of this application are also intended to include plural forms like "one or more", unless otherwise specified in the context clearly. It should be further understood that in the following embodiments of this application, "at least one" and "one or more" refer to one, two, or more.

Reference to "an embodiment" and the like described in the specification means that one or more embodiments of this application include a specific feature, structure, or characteristic described with reference to the embodiment. Therefore, the statements, such as "in an embodiment", "in some other embodiments", and "in still other embodiments", that appear at different places in the specification do not necessarily refer to a same embodiment, but mean "one or more but not all embodiments", unless otherwise specified. The terms "include", "comprise", "have", and their variants all mean "include but are not limited to", unless otherwise specifically emphasized.

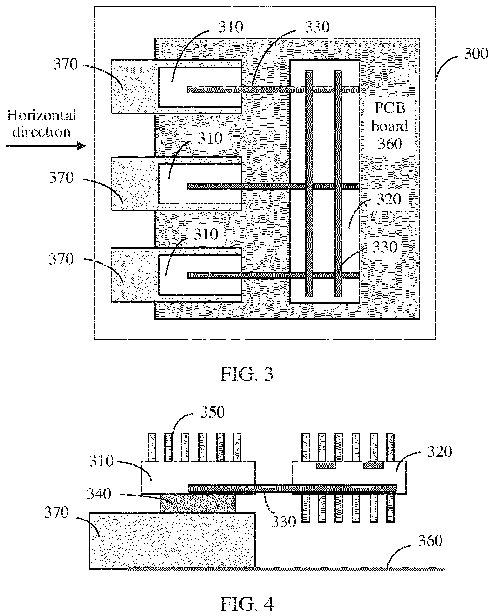

FIG. 3 is a top view of a heat dissipation apparatus for an optical module according to an embodiment of this application. As shown in FIG. 3, a heat dissipation apparatus 300 includes a plurality of optical module heat sinks 310, a common heat sink 320, and a plurality of heat pipes 330. In addition, for ease of description, an optical module 370 and a PCB board 360 are further included in this embodiment. After being plugged into a communication device, the optical module 370 forms a circuit connection with the PCB board 360. As shown in FIG. 3, the corresponding optical module heat sink 310 is installed on each optical module 370. In addition, at a rear end of each optical module heat sink 310, the common heat sink 320 is further installed in the heat dissipation apparatus.

Specifically, as shown in FIG. 3, the heat pipes 330 are embedded between the optical module heat sinks 310 and the common heat sink 320 in a horizontal direction. The heat pipes 330 may communicate the optical module heat sinks 310 with the common heat sink 320, to transfer heat of the optical modules to the common heat sink 320, to prevent overloading of a single optical module heat sink. In addition, the heat pipes 330 are embedded inside the common heat sink 320 in a vertical direction to even out the temperature difference in the common heat sink. Through the foregoing heat dissipation apparatus, a temperature difference between the plurality of optical modules can be reduced, and temperature cascading of the optical modules can be implemented, thereby implementing sharing of heat dissipation resources in the entire heat dissipation apparatus, and improving a heat dissipation capability of the optical modules.

It should be understood that a quantity of heat pipes 330 may be determined based on an amount of heat emitted by the optical modules. For example, when the optical modules radiate a large amount of heat, a plurality of heat pipes arranged side by side may be used.

FIG. 4 is a side view of the heat dissipation apparatus for an optical module shown in FIG. 3 according to an embodiment of this application. As shown in FIG. 4, in a possible implementation, the heat dissipation apparatus for an optical module further includes a boss 340. The boss 340 is configured to conduct heat of the optical module to the optical module heat sink 310. One end of the boss 340 is in contact with the optical module, and is configured to absorb heat from a surface of the optical module, and transfer the heat to the other end of the boss through the boss itself. The other end of the boss 340 is in contact with the optical module heat sink 310. Using FIG. 4 as an example, an upper surface of the boss 340 is in contact with a lower surface of the optical module heat sink 310, and a lower surface of the boss 340 is in contact with the optical module. For example, the boss 340 may be made of a metal material, so that the heat generated by the optical module is conducted to the upper surface, and the heat is absorbed by the optical module heat sink. For example, the heat dissipation apparatus further includes a heat sink fin 350. The heat sink fin 350 may be welded on an upper surface of the optical module heat sink 310 and an upper surface and a lower surface of the common heat sink, and is configured to dissipate heat. Specifically, the heat sink fin 350 is made of a metal material.

It should be noted that, a connection mode between the boss 340 and the optical module heat sink 310 is not limited in this embodiment of this application. There are a plurality of connection modes between the boss 340 and the optical module heat sink 310, for example, a permanent connection, that is, the boss 340 and the optical module heat sink 310 are fastened relative to each other in a second direction, for example, welded together, and for another example, a movable connection, that is, the boss 340 and the optical module heat sink 310 may be movable relative to each other in a second direction. For example, the boss 340 and the optical module heat sink 310 are an integrated structural part. Alternatively, the boss 340 and the optical module heat sink 310 may be connected in another mode. It should also be noted that, the heat dissipation apparatus in this application may include a plurality of bosses, and each boss corresponds to one optical module and one optical module heat sink.

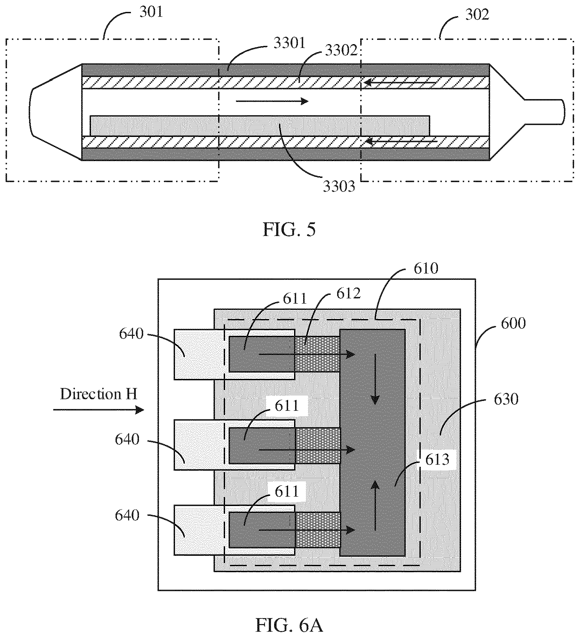

FIG. 5 is a schematic diagram of an internal structure of a heat pipe according to an embodiment of this application. As shown in FIG. 5, the heat pipe 330 includes a heat pipe housing 3301, a capillary layer 3302, and a phase change working substance 3303. The housing 3301 is usually made of a metal material such as copper. The capillary layer 3302 is generally made of copper powder or copper mesh, and sintered on an inner surface of the housing 3301. The phase change working substance 3303 is usually water. An inner cavity of the heat pipe 330 is pumped into a vacuum or a negative pressure state. A working principle of the heat pipe 330 is as follows: When a hot end 301 of the heat pipe is heated, the phase change working substance quickly evaporates into steam, and the steam quickly diffuses to a cold end 302 under a small pressure difference, releases heat at the cold end 302, and re-condenses into liquid. The condensed liquid is then returned to the hot end 301 by a capillary force of the capillary layer 3302, and the process is repeated. In addition, the heat released at the cold end 302 is then transferred to a common heat sink 320, and is dissipated to an external airflow through the fin on the common heat sink 320, so that heat is quickly transferred, and the temperature of the entire heat dissipation apparatus is balanced.

For example, a plurality of heat pipes 330 arranged side by side may be used in an inner cavity of the common heat sink 320 for internal heat uniformity.

For example, the plurality of optical module heat sinks are parallel to each other in a horizontal direction, and are all perpendicular to the common heat sink. The plurality of first heat dissipation parts are arranged in parallel in a horizontal direction, and in addition, are all perpendicular to the second heat dissipation part and in a piano keyboard shape as a whole. This can effectively reduce a volume of the heat dissipation apparatus and improve heat dissipation efficiency of a communication device.

In conclusion, through the heat dissipation apparatus for an optical module provided in this embodiment, the heat pipes may communicate the optical module heat sinks with the common heat sink, so that heat of the optical modules is transferred to the common heat sink, to prevent overloading of a single optical module heat sink. Through the foregoing heat dissipation apparatus, a temperature difference between the plurality of optical modules can be reduced, and temperature cascading of the optical modules can be implemented, thereby implementing sharing of heat dissipation resources in the entire heat dissipation apparatus, and improving a heat dissipation capability of the optical modules.

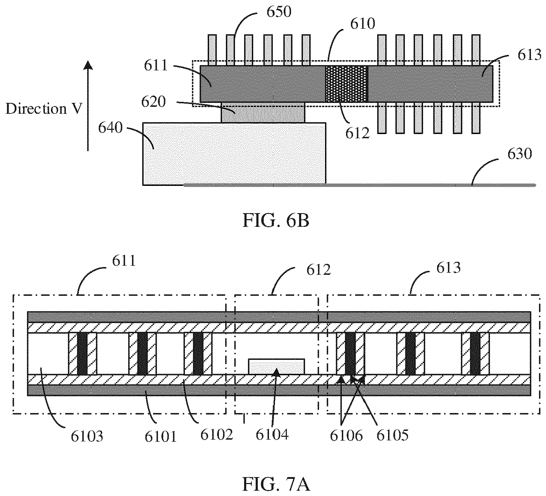

FIG. 6A and FIG. 6B show another heat dissipation apparatus for an optical module according to an embodiment of this application.

FIG. 6A is a top view of a heat dissipation apparatus for an optical module according to an embodiment of this application. FIG. 6B is a side view of the heat dissipation apparatus for an optical module shown in FIG. 6A according to an embodiment of this application. As shown in FIG. 6A and FIG. 6B, a heat dissipation apparatus 600 provided in this embodiment includes a heat dissipation substrate 610 and a boss 620. In addition, for ease of description, an optical module 640 and a PCB board 630 are further included in this embodiment. After being plugged into a communication device, the optical module 640 forms a circuit connection with the PCB board 630. The heat dissipation substrate 610 specifically includes a plurality of first heat dissipation parts 611, a plurality of adapter parts 612, and a second heat dissipation part 613. The plurality of first heat dissipation parts are in a one-to-one correspondence with the plurality of adapter parts. The first heat dissipation part 611 is located above the optical module 640, and is configured to absorb heat of a single optical module, and transfer the heat to the second heat dissipation part 613 through the adapter part 612. The second heat dissipation part 613 is located behind all optical modules, and is a common heat sink of the optical modules. The adapter part 612 is configured to connect an end of the first heat dissipation part 611 and an end of the second heat dissipation part 613, to communicate the first heat dissipation part 611 with the second heat dissipation part 613 internally, thereby implementing sharing of heat dissipation resources in the entire heat dissipation apparatus. The first heat dissipation parts 611, the adapter parts 612, and the second heat dissipation part 613 are an integrated structural part. For example, the first heat dissipation parts 611, the adapter parts 612, and the second heat dissipation part 613 may be integrated through processes such as welding and injection molding. The boss 620 is configured to conduct heat of the optical module to the heat dissipation substrate. One end of the boss 620 is in contact with the optical module, and is configured to absorb heat from a surface of the optical module. The other end of the boss 620 is in contact with the first heat dissipation part, and conduct the heat of the optical module to the heat dissipation substrate through the boss 620 itself. For example, the one end of the boss 620 is an upper surface, and the other end is a lower surface. The upper surface of the boss 620 is welded to a lower surface of the first heat dissipation part 611, the lower surface of the boss 620 is in contact with the optical module, and the boss 620 may be made of a metal material. In this way, heat generated by the optical module is conducted to the upper surface, and is absorbed by the optical module heat sink. A direction of an arrow in FIG. 6A indicates a flow direction of heat.

Optionally, a fin 650 may be further arranged on an upper surface of the first heat dissipation part 611, and on an upper surface and a lower surface of the second heat dissipation part 613, to increase a heat dissipation area of the heat dissipation substrate 610, and further improve a heat dissipation effect of the optical module 640. Specifically, the fin 650 may be welded to the upper surface of the first heat dissipation part 611 and the upper surface and the lower surface of the second heat dissipation part 613. Preferably, the fin 650 is made of a metal material. Alternatively, the fin 650 may be arranged at another position on a surface of the heat dissipation substrate. This is not limited in this application. Alternatively, in some implementations, the fin 650 may be omitted.

Based on the heat dissipation apparatus provided in this embodiment, when the heat dissipation apparatus is working, heat of the optical modules is first transmitted to the first heat dissipation parts 611 through the bosses, and the first heat dissipation parts 611 may dissipate a part of the heat. For example, the first heat dissipation part 611 dissipates a part of the heat through the fin 650 located on the upper surface of the first heat dissipation part 611. In addition, because the first heat dissipation parts 611 communicate with the second heat dissipation part 613 through the adapter parts 612, residual heat of the optical modules may be respectively transmitted to the second heat dissipation part 613, and pass through the second heat dissipation part 613 to be carried away by air flows, so that heat dissipation resources are shared by the optical modules, a temperature difference between the modules is reduced, and temperature constancy in the communication device is achieved.

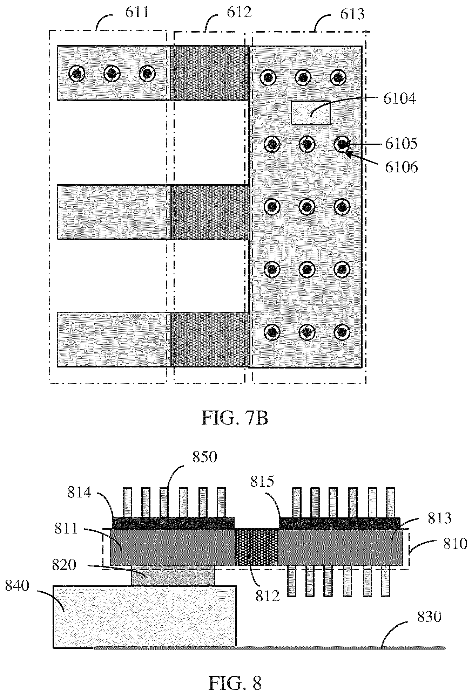

FIG. 7A is a side cross-sectional view of a heat dissipation substrate according to an embodiment of this application, and FIG. 7B is a top cross-sectional view of the heat dissipation substrate shown in FIG. 7A according to an embodiment of this application. As shown in FIG. 7A, in a possible implementation, a heat dissipation substrate 610 includes a substrate housing 6101, a capillary structure layer 6102, a vacuum cavity 6103, a phase change working substance 6104, a support column 6105, and a capillary powder layer 6106. In an implementation, the substrate housing 6101 may be made of a metal material, for example, a metal plate such as an aluminum plate, a copper plate, or an iron plate, or another rigid metal material. The capillary structure layer 6102 is sintered on an upper layer and a lower layer of an inner surface of the substrate housing 6101. It should be noted that, a first heat dissipation part 611, an adapter part 612, and a second heat dissipation part 613 of the heat dissipation substrate are integrally formed. In a current implementation, it may be understood as that the substrate housing 6101 and the capillary structure layer 6102 of the heat dissipation substrate 610 are integrally formed. The capillary structure layer 6102 may be, but is not limited to, metal powder or metal mesh. The vacuum cavity 6103 is located between the two, upper and lower, capillary structure layers 6102 and is obtained through vacuumization. The phase change working substance 6104, for example, water, is arranged in the vacuum cavity 6103 and is configured to convert heat of an optical module. The support column 6105 is located between an upper layer and a lower layer of the substrate housing 6101 and is configured to stretch the substrate housing 6101. It should be noted that, because the substrate housing 6101 and the capillary structure layer 6102 are integrally formed, it may also be said that the support column 6105 is located between an upper layer and a lower layer of the capillary structure layer 6102 and is configured to stretch the capillary structure layer 6102. The capillary powder layer 6106 is circumferentially sintered on an outer layer of the support column 6105. The capillary powder layer 6106 may be metal powder. The metal powder and the metal powder forming the capillary structure layer 6102 may be made of a same material. After the heat generated by the optical module is cooled and liquefied on an upper layer of the heat dissipation substrate, the capillary powder layer 6106 or the capillary structure layer 6102 is configured to guide the cooled and liquefied liquid to a lower layer of the heat dissipation substrate through the drive of a capillary force, to implement thermal cycling of the phase change working substance.

It should be noted that, the vacuum cavity can enable the phase change working substance 6104 to reach a state in which the phase change working substance 6104 is very easily evaporated, thereby implementing fast heat dissipation of the optical module, and ensuring that an inner wall of the heat dissipation substrate is not corroded or contaminated.

It should also be noted that, in FIG. 7A and FIG. 7B of this embodiment, a shape of the phase change working substance 6104 is designed to be a block shape, and the phase change working substance 6104 is arranged at some positions in an inner cavity of the heat dissipation substrate, which is merely for ease of description. However, this neither means that the phase change working substance is a solid, nor means that distribution of the phase change working substance is limited to the position in the figure. Actually, in a possible implementation, the phase change working substance may be liquid, and the liquid is distributed on throughout a lower surface of the inner cavity of the heat dissipation substrate.

A working principle of the heat dissipation apparatus is as follows: When the optical module 640 works, heat is conducted to a bottom of the first heat dissipation part 611 through the boss 620, the phase change working substance 6104 in the vacuum cavity 6103 absorbs the heat to be gasified, and the gasified gas quickly diffuses everywhere in the vacuum cavity of the heat dissipation substrate. Due to the presence of the heat dissipation fin 650 exists an upper surface of the first heat dissipation part and an upper surface and a lower surface of the second heat dissipation part of the heat dissipation substrate, a temperature of the heat dissipation substrate is lower than a temperature of the gasified gas. The gas is cooled and liquefied on the upper surface of the first heat dissipation part and the upper surface and the lower surface of the second heat dissipation part of the heat dissipation substrate, to release heat, and the heat is dissipated through the heat dissipation fin 650. The liquefied liquid is driven back to a lower surface of the first heat dissipation part 611 of the heat dissipation substrate by the capillary force along the capillary structure layer 6102 and the capillary powder layer 6106. The process is continuously circulated. Heat of each optical module is diffused to everywhere in the inner cavity of the heat dissipation substrate, and finally is taken away by air flows through the heat dissipation fin, thereby implementing sharing of heat dissipation resources between optical modules, and reducing a temperature difference between the modules.

For example, the plurality of first heat dissipation parts are parallel to each other in a horizontal direction, and are all perpendicular to the second heat dissipation part. The plurality of first heat dissipation parts are arranged in parallel in a horizontal direction, and in addition, are all perpendicular to the second heat dissipation part and in a piano keyboard shape as a whole. This can effectively reduce a volume of the heat dissipation apparatus and improve heat dissipation efficiency of a communication device.

For example, materials of the capillary structure layer and the fine capillary powder layer both are copper powder, and phase change working substances of the capillary structure layer and the fine capillary powder layer are water.

It should be noted that, selection of a phase change working substance 6104 is mainly related to a working temperature of the heat dissipation apparatus, and liquid properties, such as a specific heat capacity and a boiling point, are also factors taken into account. A general working temperature of the existing heat dissipation apparatuses is about 60 degrees Celsius. Therefore, water is generally used as the phase change working substance. Because in liquids, water has a high specific heat capacity and a low freezing point, is easy to boil and low in costs, water is generally the first choice for the heat dissipation apparatus. Certainly, if the heat dissipation apparatus has a low temperature, substances, such as acetone and liquid ammonia, may also be used because acetone and liquid ammonia have low freezing points, which can prevent the heat dissipation apparatus from failing to normally dissipate heat due to freezing of the phase change working substance during working. In addition, a chemical substance, such as anhydrous alcohol, may also be used as the phase change working substance. Specifically, this is not limited in this application.

Preferably, no support column 6105 or capillary powder layer 6106 is arranged in an inner cavity of the adapter part 612. In this way, the adapter part may design to be flexible to absorb a tolerance brought by insertion and removal of the optical module, to ensure normal insertion and removal of the optical module. It should be noted that, different optical modules may have different shapes and sizes, and a position and a height of the second heat dissipation part of the heat dissipation substrate are permanent in a communication device. When optical modules with different shapes and heights are inserted into the communication device, because the adapter parts are designed to be flexible, sufficient space may be provided under the first heat dissipation part, to ensure normal insertion and removal of the optical modules.

There are various connection modes between the boss 620 and the first heat dissipation part 611, for example, a permanent connection, that is, the boss 620 and the first heat dissipation part 611 are fastened relative to each other in a second direction, for example, welded together, and for another example, a movable connection, that is, the boss 620 and the first heat dissipation part 611 are movable relative to each other in a second direction. Alternatively, an elastic structure or an elastic material is used for the boss 620, and has a specific telescopic space in the second direction. In this way, when the optical modules with different heights are inserted into the communication device, heights of the bosses may be correspondingly changed, so that the optical modules can be smoothly inserted. For example, the boss 620 and the first heat dissipation part 611 are an integrated structural part. Alternatively, the boss 620 and the first heat dissipation part 611 may be connected in another mode.

It should be noted that, all first directions in this application are a direction H shown in FIG. 6A, that is, a direction parallel to the insertion direction of the optical module 640. All second directions in this application are a direction V shown in FIG. 6B, that is, a direction perpendicular to the insertion direction of the optical module.

Optionally, to achieve a better heat conduction effect, the boss 620 may include a thermal pad. The thermal pad may be bonded to the first heat dissipation part by a bonding structure, or may be connected to the first heat dissipation part by a connector. Certainly, another connection structure may alternatively be used to connect the thermal pad to the first heat dissipation part. Specifically, heat-conducting members, such as a heat-conducting graphene, may be used as the boss.

It should be understood that, regardless of how the boss 620 is connected to the first heat dissipation part 611, to improve heat conduction efficiency, the boss should preferably be in surface contact with the first heat dissipation part. In this way, compared with discrete point contact, surface contact can effectively improve the heat conduction efficiency.

It should be noted that, flatness and roughness of contact surfaces between the boss 620 and the first heat dissipation part 611 need to be as small as possible, to reduce thermal resistance between the contact surfaces and improve the heat conduction efficiency. It should be noted that, flatness, also referred to as evenness, is one of the key indicators for evaluating quality of a formed surface, and is a deviation of a measured surface height from an ideal plane, which directly affects a bonding effect and fastening performance between components. Roughness refers to unevenness of a to-be-measured surface with small gaps and tiny peaks and valleys. The smaller the roughness of a surface, the smoother the surface.

In conclusion, through the heat dissipation apparatus for an optical module provided in this embodiment, the adapter parts may communicate the optical module heat sinks (the first heat dissipation parts) with the common heat sink (the second heat dissipation part), so that heat of the optical modules is transferred to the common heat sink, to prevent overloading of a single optical module heat sink. Through the foregoing heat dissipation apparatus, a temperature difference between the plurality of optical modules can be reduced, and temperature cascading of the optical modules can be implemented, thereby implementing sharing of heat dissipation resources in the entire heat dissipation apparatus, and improving a heat dissipation capability of the optical modules.

FIG. 8 is a side view of another heat dissipation apparatus for an optical module according to an embodiment of this application. As shown in FIG. 8, a heat dissipation apparatus 800 includes a heat dissipation substrate 810 and a boss 820. In addition, for ease of description, an optical module 840 and a PCB board 830 are further included in this embodiment. After being plugged into a communication device, the optical module 840 forms a circuit connection with the PCB board 830. Similar to the heat dissipation apparatus shown in FIG. 6A and FIG. 6B, the heat dissipation substrate 810 in this embodiment also includes a plurality of first heat dissipation parts 811, a plurality of adapter parts 812 that are in a one-to-one correspondence thereto, and a second heat dissipation part 813.

Different from the heat dissipation apparatus for an optical module shown in FIG. 6A and FIG. 6B, the heat dissipation apparatus for an optical module provided in this embodiment further includes a first substrate 814 and a second substrate 815.

Specifically, the first substrate 814 is located above the first heat dissipation parts 811, and is configured to support the first heat dissipation parts and assist the first heat dissipation parts 811 in performing heat dissipation. The second substrate 815 is located above the second heat dissipation part 813, and is configured to support the second heat dissipation part and assist the second heat dissipation part 813 in performing heat dissipation. It should be noted that, in the heat dissipation apparatus for an optical module shown in FIG. 6A and FIG. 6B, the heat dissipation substrate 610 is essentially a phase change substrate, and a main function of the heat dissipation substrate 610 is to quickly transfer heat of the optical module, and the heat dissipation effect is limited. In addition, a support column needs to be arranged inside the heat dissipation substrate to support an inner cavity of the heat dissipation substrate. In this embodiment, the first substrate and the second substrate are respectively added to the first heat dissipation part and the second heat dissipation part, and not only replace the support column to support the first heat dissipation part and the second heat dissipation part of the heat dissipation substrate, simplify a manufacturing process of the heat dissipation substrate and reduce heat dissipation costs, but also can assist the first heat dissipation part and the second heat dissipation part in dissipating heat, and quickly transfer the heat of the optical module to the outside of the device, to improve heat dissipation efficiency.

For example, the first substrate 814 is welded to an upper surface of the first heat dissipation part 811. The second substrate is welded to an upper surface of the second heat dissipation part 813. The adapter part 812 remains flexible, to absorb a tolerance brought by insertion and removal of the optical module, and ensure normal insertion and removal of the optical module. Alternatively, the first substrate 814 is welded to a lower surface of the first heat dissipation part 811, and the second substrate is welded to a lower surface of the second heat dissipation part 813. Alternatively, the first substrate 814 may be connected to the first heat dissipation part in another mode. A connection mode between the first substrate and the first heat dissipation part and a connection mode between the second substrate and the second heat dissipation part are not limited in this embodiment.

For example, the first substrate or the second substrate may be a metal plate. Because of having some rigidity, the metal plate not only can support the heat dissipation substrate, but also has good thermal conductivity, which can improve heat dissipation efficiency of the heat dissipation apparatus.

Optionally, a fin 850 may be further arranged on the upper surface of the first heat dissipation part 811, and on the upper surface and the lower surface of the second heat dissipation part 813, to increase a heat dissipation area of the heat dissipation substrate 810, and further improve a heat dissipation effect of the optical module 840. Specifically, the fin 850 may be welded to the upper surface of the first heat dissipation part 811 and the upper surface and the lower surface of the second heat dissipation part 813. Preferably, the fin 850 is made of a metal material.

Certainly, the fin 850 may alternatively be arranged at another position on a surface of the heat dissipation substrate. This is not limited in this application. Alternatively, in some implementations, the fin 850 may be omitted.

When the heat dissipation apparatus works, heat of the optical modules is first transmitted to the first heat dissipation parts through the bosses. The first heat dissipation parts may dissipate a part of the heat, for example, dissipate a part of the heat through the first substrate on the upper surface thereof. In addition, because the first heat dissipation parts 611 communicate with the second heat dissipation part 613 internally through the adapter parts 612, residual heat of the optical modules may be respectively transmitted to the second heat dissipation part 613, and pass through the second substrate located on the upper surface of the second heat dissipation part 613 to be dissipated outside the communication device. In this way, heat dissipation resources are shared by the optical modules, a temperature difference between the modules is reduced, and temperature constancy in the communication device is achieved.

In this embodiment, for an internal structure of the heat dissipation substrate 810, a connection mode between the boss 820 and the heat dissipation substrate 810, a position and a specific function of each component, and the like, refer to the foregoing embodiments. Details are not described herein again.

In addition, embodiments of this application further provide a communication device. For details, refer to the communication device 20 shown in FIG. 1. The communication device includes: the heat dissipation apparatus for an optical module according to the foregoing embodiments, a PCB board, and the optical module. The PCB board has a jack, the optical module is inserted into the communication device through the jack, and heat generated by the optical module is dissipated outside the communication device through the heat dissipation apparatus for an optical module. During specific implementation, the communication device may be a device such as a switch, a router, or a gateway. A type of the communication device is not limited in this application.

It should be understood that, during specific implementation, a quantity of heat dissipation apparatuses for an optical module used in the communication device 20 may be properly set based on an actual situation. This is not limited in this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation apparatus for an optical module, comprising:
a heat dissipation substrate, comprising a plurality of first heat dissipation parts, a plurality of adapter parts, and a second heat dissipation part, wherein the plurality of first heat dissipation parts are in a one-to-one correspondence with the plurality of adapter parts, each adapter part is configured to connect the first heat dissipation part corresponding thereto and the second heat dissipation part, and the plurality of first heat dissipation parts, the plurality of adapter parts, and the second heat dissipation part are integrally formed; and
a plurality of bosses, in a one-to-one correspondence with the plurality of first heat dissipation parts, and configured to conduct heat of the optical module to the heat dissipation substrate, wherein one end of the boss is in contact with the optical module, and the other end of the boss is in contact with the corresponding first heat dissipation part.

2. The heat dissipation apparatus according to claim 1, wherein the plurality of first heat dissipation parts, the plurality of adapter parts, and the second heat dissipation part each comprise a substrate housing and a capillary structure layer, wherein the capillary structure layer is sintered on an inner surface of the substrate housing to implement cyclic heat dissipation, and that the plurality of first heat dissipation parts, the plurality of adapter parts, and the second heat dissipation part are integrally formed comprises: the substrate housing and the capillary structure layer are integrally formed.

3. The heat dissipation apparatus according to claim 2, wherein the heat dissipation substrate further comprises a vacuum cavity, wherein
the vacuum cavity is obtained by vacuumizing an inner cavity of the heat dissipation substrate, and the vacuum cavity is filled with a phase change working substance to transfer the heat of the optical module through gasification.

4. The heat dissipation apparatus according to claim 3, wherein that each adapter part is configured to connect the first heat dissipation part corresponding thereto and the second heat dissipation part comprises: each first heat dissipation part, each adapter part, and the second heat dissipation part communicate with each other through the vacuum cavity.

5. The heat dissipation apparatus according to claim 3, wherein the phase change working substance is water.

6. The heat dissipation apparatus according to any one of claims 1 to 5, wherein the first heat dissipation parts and the second heat dissipation part further each comprise a support column and a capillary powder layer, wherein the support column is located between an upper layer and a lower layer of the substrate housing and is configured to support the substrate housing, and the capillary powder layer is circumferentially sintered on an outer layer of the support column; and after the heat generated by the optical module is cooled and liquefied on an upper layer of the heat dissipation substrate, the capillary powder layer or the capillary structure layer is configured to guide the cooled and liquefied liquid to a lower layer of the heat dissipation substrate.

7. The heat dissipation apparatus according to claim 2 or 6, wherein a material of the capillary structure layer and/or a material of the capillary powder layer are/is copper powder.

8. The heat dissipation apparatus according to any one of claims 1 to 5, wherein the heat dissipation apparatus further comprises:
a first substrate, wherein the first substrate is welded on a surface of the first heat dissipation part, and is configured to support the first heat dissipation part and assist the first heat dissipation part in dissipating heat; and/or
a second substrate, wherein the second substrate is welded on a surface of the second heat dissipation part, and is configured to support the second heat dissipation part and assist the second heat dissipation part in dissipating heat.

9. The heat dissipation apparatus according to claim 8, wherein the first substrate or the second substrate is a metal plate.

10. The heat dissipation apparatus according to any one of claims 1 to 9, wherein the plurality of first heat dissipation parts are parallel to each other in a first direction, and are arranged side by side and perpendicular to the second heat dissipation part, wherein the first direction is an insertion and removal direction of the optical module.

11. The heat dissipation apparatus according to any one of claims 1 to 10, wherein the heat dissipation apparatus further comprises a heat dissipation fin, wherein the heat dissipation fin is arranged on an outer surface of the heat dissipation substrate, and is configured to dissipate heat to the outside of the heat dissipation apparatus.

12. The heat dissipation apparatus according to claim 2 or 3, wherein the substrate housing is made of a rigid metal material.

13. The heat dissipation apparatus according to any one of claims 1 to 12, wherein that the other end of the boss is in contact with the corresponding first heat dissipation part specifically comprises: an upper surface of the boss is welded to a lower surface of the corresponding first heat dissipation part.

14. The heat dissipation apparatus according to any one of claims 1 to 13, wherein the boss is made of a heat-conducting graphene material.

15. A communication device, comprising: the heat dissipation apparatus for an optical module according to any one of claims 1 to 14, a PCB board, and the optical module, wherein the PCB board has a jack, configured for insertion of the optical module.
